(19) Europäisches Patentamt
European Patent Office
Office européen des brevets

(11) **EP 1 772 775 B1**

(12) **EUROPÄISCHE PATENTSCHRIFT**

(45) Veröffentlichungstag und Bekanntmachung des Hinweises auf die Patenterteilung:
**05.11.2008  Patentblatt 2008/45**

(21) Anmeldenummer: **06025651.8**

(22) Anmeldetag: **23.12.1999**

(51) Int Cl.:
*G03F 7/20* $^{(2006.01)}$         *G02B 17/06* $^{(2006.01)}$

(54) **Mikrolithographie-Reduktionsobjektiveinrichtung sowie Projektionsbelichtungsanlage**

Microlithographic reduction lens and projection illumination system

Dispositif à objectif de réduction pour la microlithographique ainsi qu'une installation d'éclairage à projection

(84) Benannte Vertragsstaaten:
**DE FR GB NL**

(30) Priorität: **15.02.1999   DE 19906001**
              **07.10.1999   DE 19948240**

(43) Veröffentlichungstag der Anmeldung:
**11.04.2007   Patentblatt 2007/15**

(62) Dokumentnummer(n) der früheren Anmeldung(en) nach Art. 76 EPÜ:
**99125783.3 / 1 035 445**

(73) Patentinhaber: **Carl Zeiss SMT AG**
**73447 Oberkochen (DE)**

(72) Erfinder: **Dinger, Udo**
**73447 Oberkochen (DE)**

(74) Vertreter: **Sawodny, Michael-Wolfgang**
**Dreiköniggasse 10**
**89073 Ulm (DE)**

(56) Entgegenhaltungen:
**EP-A- 0 779 528            WO-A-99/57606**
**US-A- 5 686 728**

• **JEWELL T E: "Optical system design issues in development of projection camera for EUV lithography" PROCEEDINGS OF THE SPIE, SPIE, BELLINGHAM, VA, US, Bd. 2437, 20. Februar 1995 (1995-02-20), Seiten 340-346, XP002112301**

**Beschreibung**

Die Erfindung betrifft ein Mikrolithographieobjektiv gemäß dem Oberbegriff von Anspruch 1, eine Projektionsbelichtungsanlage gemäß Anspruch 24 sowie ein Chipherstellungsverfahren gemäß Anspruch 27.

Die Lithographie mit Wellenlängen < 193 nm, insbesondere die EUV-Lithographie mit $\lambda$ = 11 nm bzw. $\lambda$ = 13 nm werden als mögliche Techniken zur Abbildungen von Strukturen < 130 nm, besonders bevorzugt < 100 nm diskutiert. Die Auflösung eines lithographischen Systems wird durch nachfolgende Gleichung beschrieben:

$$RES = k_1 \cdot \frac{\lambda}{NA}$$

wobei k1 ein spezifischer Parameter des Lithographieprozesses, $\lambda$ die Wellenlänge des einfallenden Lichtes und NA die bildseitige, numerische Apertur des Systems bezeichnet.

Für abbildende Systeme im EUV-Bereich stehen als optische Komponenten im wesentlichen reflektive Systeme mit Multilayer-Schichten zur Verfügung. Als Multilayer-Schichtsysteme finden bei $\lambda$ = 11 nm bevorzugt Mo/Be-Systeme und bei $\lambda$ = 13 nm Mo/Si-Systeme Verwendung.

Legt man eine eine numerische Apertur von 0,2 zugrunde, so erfordert die Abbildung von 50 nm-Strukturen mit 13 nm-Strahlung einen vergleichsweise einfachen Prozeß mit $k_1$ = 0,77. Mit $k_1$ = 0,64 wird bei 11 nm-Strahlung die Abbildung von 35 nm-Strukturen möglich.

Da die Reflektivität der eingesetzten Multilayer-Schichten nur im Bereich von ungefähr 70 % liegt, ist es bei den Projektionsobjektiven für die EUV-Mikrolithographie von ganz entscheidender Bedeutung, zum Erreichen einer ausreichenden Lichtstärke mit möglichst wenig optischen Komponenten im EUV-Projektionsobjektiv auszukommen.

Als besonders bevorzugt haben sich mit Blick auf eine hohe Lichtintensität und ausreichende Möglichkeiten zur Korrektur von Abbildungsfehlern bei NA = 0,20 Systeme mit sechs Spiegeln herausgestellt.

6-Spiegel-Systeme für die Mikrolithographie sind aus den Druckschriften US-A-5686728 und EP 0779528 bzw. US 5815310 bekannt geworden.

Das Projektions-Lithographiesystem gemäß der US-A-5686728 zeigt ein Projektionsobjektiv mit sechs Spiegeln, wobei jede der reflektiven Spiegelflächen asphärisch ausgebildet ist. Die Spiegel sind entlang einer gemeinsamen optischen Achse so angeordnet, daß ein obskurationfreier Lichtweg erreicht wird.

Da das aus der US-A-5686728 bekannte Projektionsobjektiv nur für UV-Licht mit einer Wellenlänge von 100 - 300 nm eingesetzt wird, weisen die Spiegel dieses Projektionsobjektives eine sehr hohe Asphärizität von ungefähr +/-50 $\mu$m sowie sehr große Einfallswinkel von ca. 38° auf. Auch nach Abblenden auf NA = 0,2 verbleibt hier eine Asphärizität von 25 $\mu$m von Spitze zu Spitze bei kaum vermindertem Einfallswinkel. Derartige Asphärizitäten und Einfallwinkel sind im EUV-Bereich wegen der hohen Anforderungen an die Oberflächenqualität, Reflektivität der Spiegel nach heutigem Stand der Technik nicht praktikabel.

Ein weiterer Nachteil des aus der US-A-5686728 bekannt gewordenen Objektives, der einen Einsatz im Bereich von $\lambda$ < 100 nm, insbesondere bei den Wellenlängen von 11 und 13 nm nicht mehr erlaubt, ist der sehr geringe Abstand zwischen dem Wafer und dem dem Wafer am nächsten liegenden Spiegel. Bei den aus der US-A-5686728 bekanntgewordenen Abständen von Wafer und wäfernächstem Spiegel können die Spiegel nur sehr dünn ausgebildet werden. Wegen der extremen Schicht-Spannungen in den Multilayer-Systemen für die angesprochenen Wellenlängen von 11 und 13 nm sind derartige Spiegel sehr instabil.

Aus der EP-A-0779528 ist ein Projektionsobjektiv mit sechs Spiegeln zum Einsatz in der EUV-Lithographie, insbesondere auch bei Wellenlängen von 13 nm und 11 nm, bekanntgeworden.

Auch dieses Projektionsobjektiv hat den Nachteil, daß mindestens zwei der insgesamt sechs Spiegel sehr hohe Asphärizitäten von 26 bzw. 18,5 $\mu$m aufweisen. Insbesondere ist aber auch bei der aus der EP-A-0779528 bekannten Anordnung der optische freie Arbeitsabstand zwischen wafernächstem Spiegel und Wafer derart gering, daß es entweder zu Instabilitäten oder aber einem mechanisch freien Arbeitsabstand, der negativ ist, kommt.

Aufgabe der Erfindung ist es somit, eine für die Lithographie mit kurzen Wellenlängen < 100 nm geeignete Projektionsobjektiveinrichtung anzugeben, die die zuvor erwähnten Nachteile des Standes der Technik nicht aufweist.

Erfindungsgemäß wird die Aufgabe gelöst, durch ein Mikrolithographie-Projektionsobjektiv für Wellenlängen < 100 nm mit einem ersten Spiegel (S1), einem zweiten Spiegel (S2), einem dritten Spiegel (S3), einem vierten Spiegel (S4), einem fünften Spiegel (S5) und einem sechsten Spiegel (S6) mit Ringfeld; wobei
die bildseitige numerische Apertur (NA) $\geq$ 0,15 ist,
die bildseitige Breite eines Ringfeldes W $\geq$ 1,0 mm ist, **dadurch gekennzeichnet**, dass Einfallswinkel (AOI) relativ zur Flächennormalen aller Strahlen auf allen Spiegeln durch

$$AOI \leq 23° - 35° \ (0,25 - NA) - 0,2° /_{mm} \ (2 \ mm - W)$$

beschränkt sind, wobei
NA: bildseitige numerische Apertur
W: bildseitige Breite eines Ringfeldes

In einer weiteren Ausgestaltung der Erfindung ist bei einem Projektionsobjektiv mit sechs Spiegeln der wafernächste Spiegel derart angeordnet, daß die bildseitige numerische Apertur größer gleich 0,15 ist und der waferseitige optische freie Arbeitsabstand mindestens dem genutzten Durchmesser des wafernächsten Spiegels entspricht und/oder der waferseitige optische freie Arbeitsabstand mindestens der Summe aus einem Drittel des genutzten Durchmessers dieses Spiegels und einer Länge, die zwischen 20 und 30 mm liegt, beträgt und/oder der waferseitige optische freie Arbeitsabstand mindestens 50 mm, vorzugsweise 60 mm beträgt.

In einer weiteren Ausgestaltung der Erfindung ist die bildseitige numerische Apertur NA größer als 0,15, die Ringfeldbreite W am Wafer liegt im Bereich

$$1,0 \ mm \leq W$$

und die Spitze-Spitze-Abweichung A der Asphären ist gegenüber der im Nutzbereich bestpassenden Sphäre auf allen Spiegeln durch

$$A \leq 19 \ \mu m - 102 \ \mu m (0,25 - NA) - 0,7 \ \frac{\mu m}{mm} \ (2 \ mm - W)$$

beschränkt.

Besonders bevorzugt ist die Spitze-Spitze-Abweichung A der Asphären auf allen Spiegeln auf

$$A \leq 12 \ \mu m - 64 \ \mu m (0,25 - NA) - 0,3 \ \frac{\mu m}{mm} \ (2 \ mm - W)$$

beschränkt.

In einer weiteren Ausführungsform der Erfindung sind bei einer numerischen Apertur NA ≥ 0,15 und einer waferseitigen Breite des Ringfeldes W ≥ 1 mm die Einfallswinkel AOI relativ zur Flächennormalen aller Strahlen auf allen Spiegeln durch

$$AOI \leq 23° - 35° \ (0,25 - NA) - 0,2° /_{mm} \ (2 \ mm - W)$$

beschränkt.

Auch Kombinationen der zuvor aufgeführten Einzeimaßnahmen zur Lösung der erfindungsgemäßen Aufgabe sind möglich; beispielsweise können in einer besonders bevorzugten Ausgestaltung alle drei Bedingungen erfüllt sein, d.h. der freie optische Arbeitsabstand mehr als 50 mm bei NA = 0,20 betragen, die Spitze-Spitze-Abweichung der Asphären sowie die Einfallswinkel im zuvor definierten Bereich liegen.

Die in dieser Schrift diskutierten Asphärizitäten beziehen sich auf die Spitze-Spitze- bzw. peak to valley (PV)-Abweichung A der asphärischen Flächen gegenüber der im Nutzbereich bestpassenden Sphäre.

Diese werden in den Beispielen durch eine Sphäre approximiert, deren Mittelpunkt auf der Figurenachse des Spiegels liegt und die im Meridionalschnitt die Ashpäre im oberen und unteren Endpunkt des Nutzbereiches schneidet.

Die Angaben zu den Einfallswinkeln beziehen sich jeweils auf den Winkel zwischen jeweiligen einfallendem Strahl und Flächennormale am Einfallsort. Angegeben ist jeweils der größte Winkel irgendeines Strahles, im allgemeinen eines bündelbegrenzenden Strahles, der an irgendeinem der Spiegel auftritt.

Unter genutztem Durchmesser sei hier und im weiteren der Hüllkreisdurchmesser des im allgemeinen nicht kreisförmigen Nutzbereiches verstanden.

Besonders bevorzugt beträgt der waferseitige optische freie Arbeitsabstand 60 mm.

Die zuvor beschriebenen Objektive können nicht nur im EUV eingesetzt werden, sondern selbstverständlich auch bei anderen Wellenlängen, ohne daß von der Erfindung abgewichen wird.

Um Degradationen der Abbildungsgüte, beispielsweise aufgrund von Mittenabschattungen zu vermeiden, ist mit Vorteil vorgesehen, daß die Spiegel des Projektionsobjektives derart angeordnet sind, daß die Lichtführung obskurationsfrei ist.

Um eine leichte Montage und Justage des Systems zu gewährleisten, ist mit Vorteil vorgesehen, daß in einer weitergebildeten Ausführungsform der Erfindung die Spiegelflächen auf zu einer Hauptachse (HA), rotationssymmetrischen Fläche ausgebildet sind.

Um ein kompaktes Design des Objektives bei zugänglicher Blende zu erhalten, und einen obskurationsfreien Strahlengang zu realisieren, ist mit Vorteil vorgesehen, daß die Projektionsobjektiveinrichtung als System mit Zwischenbild ausgeführt ist. Besonders bevorzugt ist es, wenn das Zwischenbild nach dem vierten Spiegel ausgebildet wird. Bei derartigen Aufbauten ist es möglich, daß die Blende im vorderen, niederaperturigen Objektivteil zu liegen kommt und eine dazu konjugierte Pupillenebene in den Brennpunkt des letzten Spiegels abgebildet wird. Ein solcher Aufbau stellt einen telezentrischen Strahlengang im Bildraum sicher.

In einer weiteren Ausführungsform der Erfindung ist vorgesehen, daß die frei zugängliche Blende optisch und physikalisch zwischen zweitem und drittem Spiegel angeordnet ist.

Eine gute Zugänglichkeit der Blende ist dann gegeben, wenn der Abstand von erstem und drittem Spiegel zu erstem und zweitem Spiegel im Bereich

$$0,5 < \frac{S1S3}{S1S2} < 2$$

liegt. Um eine Abschattung des vom dritten zum vierten Spiegel laufenden Bündels durch die zwischen zweitem und drittem Spiegel angeordnete Blende zu verhindern, ist es von Vorteil, wenn das Verhältnis des Abstandes zwischen zweitem Spiegel und Blende zum Abstand von drittem Spiegel und Blende im Bereich

$$0,5 < \frac{S2\,Blende}{S3\,Blende} < 2$$

liegt. Durch einen gestreckten Aufbau, wie bei einer Ausführungsform der Erfindung realisiert, lassen sich auch die Winkelbelastungen im vorderen Teil des Projektionsobjektives senken.

Eine physikalisch zwischen S2 und S1 liegende Blende muß zumindest partiell als schmaler Ring ausgebildet werden, um ein Beschneiden des von S1 nach S2 laufenden Bündels zu vermeiden. Bei einer derartigen Ausgestaltung besteht die Gefahr, daß unerwünschtes direktes oder an S1 und S2 reflektiertes Licht die Blende außerhalb dieses Ringes passiert und den Wafer erreicht.

Setzt man die Blende optisch zwischen zweiten und dritten Spiegel und physikalisch nahe beim ersten Spiegel, so ist durch eine derartige mechanisch einfach zu realisierende Anordnung der Blende ein effizienteres Ausblenden dieser unerwünschten Strahlen möglich. Die Blende kann sowohl als Öffnung im ersten Spiegel oder hinter dem ersten Spiegel liegend ausgeführt werden.

In einer weiteren Ausführungsform der Erfindung ist vorgesehen, die Blende auf oder nahe beim zweiten Spiegel anzuordnen. Eine Anordnung der Blende auf dem Spiegel hat den Vorteil, daß sie mechanisch einfach zu realisieren ist.

Hier ist es zur Sicherstellung eines obskurationsfreien Strahlenganges bei gleichzeitig kleinen Einfallswinkeln von Vorteil, wenn

$$0,3 \le \frac{S1S3}{S1S2} \le 2,0$$

und

$$0,7 \leq \frac{S2S3}{S3S4} \leq 1,4$$

gilt.

Um die nötigen Korrekturen der Abbildungsfehler in den 6-Spiegelsystemen vornehmen zu können, sind in einer bevorzugten Ausführungsform sämtliche sechs Spiegel asphärisch ausgebildet.

Eine fertigungstechnische Vereinfachung wird erreicht, wenn in einer alternativen Ausführungsform vorgesehen ist, höchstens fünf Spiegel asphärisch auszubilden. Es ist dann möglich, einen Spiegel, vorzugsweise den größten Spiegel, hier in Gestalt des Quartärspiegels, sphärisch auszubilden.

Besonders bevorzugt ist eine Anordnung des zweiten bis sechsten Spiegels in der Reihenfolge konkav - konvex - konkav - konvex - konkav.

Um eine Auflösung von mindestens 50 nm zu erreichen, ist mit Vorteil vorgesehen, daß der Design-Anteil des rms-Wellenfrontanteils des Systems höchstens 0,07 λ, bevorzugt 0,03 λ beträgt.

Vorteilhafterweise sind in den Beispielen der Erfindung die Objektive stets bildseitig telezentrisch ausgebildet.

Bei Projektionssystemen, die mit einer Reflektionsmaske betrieben werden, ist ein telezentrischer Strahlengang ohne Beleuchtung über einen stark transmissionsmindernden Strahlteiler, wie beispielsweise aus der JP-A-95 28 31 16 bekannt, objektseitig nicht möglich. Daher sind die Hauptstrahlwinkel am Retikel so gewählt, daß eine abschattungsfreie Beleuchtung gewährleistet ist.

Bei Systemen mit Transmissionsmaske kann vorgesehen sein, daß das Projektionsobjektiv objektseitig telezentrisch ausgelegt ist. Bei derartigen Ausführungsformen ist der erste Spiegel vorzugsweise konkav ausgebildet.

Im gesamten sollte der Telezentriefehler am Wafer 10 mrad nicht überschreiten, vorzugsweise liegt er bei 5 mrad, besonders bevorzugt bei 2 mrad. Dies stellt sicher, daß sich die Änderung des Abbildungsmaßstabes über den Tiefenschärfenbereich in tolerierbaren Grenzen hält.

In den Ausführungsformen der Erfindung ist vorgesehen, daß diese einen Feldspiegel, ein verkleinerndes Drei-Spiegel-Subsystem und ein Zwei-Spiegel-Subsystem umfaßt.

Neben der erfindungsgemäßen Projektionsobjektiveinrichtung stellt die Erfindung auch eine Projektionsbelichtungsanlage, umfassend mindestens eine derartige Einrichtung, zur Verfügung. In einer ersten Ausführungsform weist die Projektionsbelichtungsanlage eine Reflektionsmaske auf, in einer alternativen Ausführungsform eine Transmissionsmaske.

Besonders bevorzugt ist es, wenn die Projektionsbelichtungsanlage eine Beleuchtungseinrichtung zur Beleuchtung eines außeraxialen Ringfeldes umfaßt und das System als Ringfeldsscanner ausgebildet ist. Mit Vorteil ist vorgesehen, daß die Sekantenlänge des Scan-Schlitzes mindestens 26 mm beträgt und die Ringbreite größer als 0,5 mm ist, so daß eine homogene Beleuchtung ermöglicht wird.

Die Erfindung soll nachfolgend anhand der Zeichnungen beispielhaft beschrieben werden.

Es zeigen:

Figur 1: Ein erstes erfindungsgemäßes System mit Zwischenbild und frei zugänglicher Blende zwischen zweitem und drittem Spiegel und numerischer Apertur von 0,2.

Figur 2: Eine 6-Spiegelanordnung für Wellenlängen > 100 nm wie aus dem Stand der Technik in Form der US-A-5686728 bekannt ist.

Figur 3: Eine zweite erfindungsgemäße Ausführungsform mit Blende zwischen zweitem und drittem Spiegel, die auf dem ersten Spiegel zu liegen kommt.

Figur 4: Eine dritte Ausführungsform der Erfindung mit Blende auf dem zweiten Spiegel und Arbeitsabstand 59 mm.

Figur 5: Eine vierte Ausführungsform der Erfindung eines Systems mit Zwischenbild, einer numerischen Apertur NA von 0,28 sowie einem bildseitigen optischen freien Arbeitsabstand, der mindestens der Summe aus einem Drittel des genutzten Durchmessers des wafernächsten Spiegels und einer Länge, die zwischen 20 und 30 mm liegt, entspricht.

Figur 6: Eine fünfte Ausführungsform der Erfindung eines Systems mit Zwischenbild und einer numerischen Apertur NA von 0,30.

Figur 7A - 7B: Definition des genutzten Durchmessers bei unterschiedlich ausgeleuchteten Lichtfeldern.

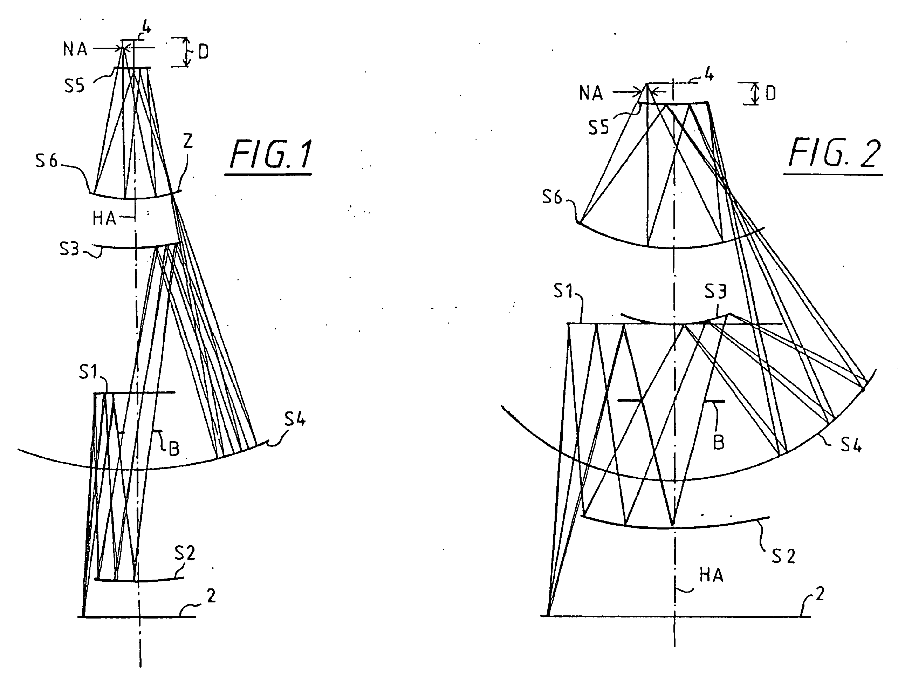

In den nachfolgenden Figuren 1 sowie 3 bis 4 sind Anordnungen von erfindungsgemäßen 6-Spiegel-Projektionsobjektiven gezeigt, die einen freien optischen Arbeitsabstand, der mindestens dem genutzten Durchmesser des wafernächsten Spiegels entspricht, aufweisen.

Figur 2 zeigt demgegenüber ein System gemäß dem Stand der Technik für Wellenlängen > 100 nm, wie beispielsweise aus der US-A-5686728 bekannt.

In sämtlichen Ausführungsformen werden nachfolgend für gleiche Bauelemente gleiche Bezugsziffern verwendet, wobei nachfolgende Nomenklatur verwendet wurde:

- erster Spiegel (S1), zweiter Spiegel (S2)
- dritter Spiegel (S3), vierter Spiegel (S4)
- fünfter Spiegel (S5), sechster Spiegel (S6).

In Figur 1 ist ein 6-Spiegel-Projektionsobjektiv gemäß der Erfindung mit Strahlengang von der Retikelebene 2 bis zur Waferebene 4 dargestellt. Die dargestellte spezielle Ausgestaltung des erfindungsgemäßen Systems kann aufgefaßt werden als Hintereinanderschaltung

- eines Feldspiegels S1, der mit Abbildungsmaßstab β > 0 ein virtuelles Bild eines Objektes erzeugt,
- eines aus S2, S3 und S4 gebildeten 3-Spiegelsystems, welches eine reelle, verkleinerte Abbildung des von S1 erzeugten virtuellen Bildes des Objektes in das System-Zwischenbild Z bewirkt und
- eines 2-Spiegelsstems S5, S6, welches das Zwischenbild Z unter Einhaltung der Telezentrieanforderungen in die Waferebene 4 abbildet.

Die Aberrationen der Subsysteme sind dabei so gegeneinander ausbalanciert, daß das Gesamtsystem eine für die Anwendung hinreichende Güte besitzt.

Die physikalische Blende B ist zwischen zweitem Spiegel S2 und drittem Spiegel S3 angeordnet. Wie deutlich aus Figur 1 hervorgeht, liegt die Blende zugänglich im Strahlengang zwischen zweitem Spiegel S2 und drittem Spiegel S3.

Beim System gemäß Figur 1 ist der optische Arbeitsabstand zwischen dem wafernächsten Spiegel, das ist in vorliegendem Ausführungsbeispiel der fünfte Spiegel S5, und der Waferebene 4 größer als der genutzte Durchmesser des Spiegels S5, d.h. es ist nachfolgende Bedingung erfüllt:

optischer Abstand S5 zur Waferebene 4 > genutzter Durchmesser S5.

Auch andere Abstandsbedinungen sind alternativ möglich, beispielsweise daß der optische Arbeitsabstand größer als die Summe aus ein Drittel des genutzten Durchmessers des wafernächsten Spiegels S5 plus 20 mm oder mehr als 50 mm ist.

Im vorliegenden Ausführungsbeispiel beträgt der freie optische Arbeitsabstand 60 mm, ohne hierauf beschränkt zu sein.

Ein derartiger optischer Arbeitsabstand garantiert einen ausreichend freien mechanischen Arbeitsabstand, der größer als 0 ist sowie die Verwendung von optischen Komponenten mit ausreichenden Festigkeitseigenschaften für Wellenlängen < 100 nm, vorzugsweise von 11 bzw. 13 nm.

Die optischen Komponenten umfassen für eine Wellenlänge λ = 13 nm und λ = 11 nm beispielsweise Mo/Si- bzw. Mo/Be-Multilayer-Schichtsysteme, wobei typische Multilayer-Schichtsysteme für λ = 13 nm 40 Mo/Si-Schichtpaare und für λ = 11 nm taugliche Mo/Be-Systeme ungefähr 70 Schichtpaare aufweisen. Die erreichbaren Reflektivitäten der Systeme liegen im Bereich von ungefähr 70 %. In den Multilayer-Schichtsystemen können Schichtspannungen von 350 MPa und mehr auftreten, die Oberflächendeformation, insbesondere in den Randbereichen der Spiegel induzieren.

Die erfindungsgemäßen Systeme, wie beispielsweise in Figur 1 dargestellt, besitzen gemäß

$$RES = \frac{k1\,\lambda}{NA}$$

eine nominelle Auflösung von mindestens 50 nm bzw. 35 nm bei einer minimalen numerischen Apertur von NA = 0,2 bei $k_1$ = 0,77 und λ = 13 nm bzw. $k_1$ = 0,64 und λ = 11 nm, wobei $k_1$ ein Lithographieprozeß-spezifischer Parameter ist.

Des weiteren ist der Strahlengang des in Fig. 1 dargestellten Objektives obskurationsfrei. Um beispielsweise Bildformate von 26 x 34 mm$^2$ bzw. 26 x 52 mm$^2$ bereitzustellen, werden die erfindungsgemäßen Projektionsobjektive vorzugsweise in Ringfeld-Scan-Projektionsbelichtungsanlagen verwendet, wobei die Sekantenlänge des Scan-Schlitzes mindestens 26 mm beträgt.

Je nach verwandter Maske in der Projektionsbelichtungsanlage, hier sind Transmissionsmasken z.B. Stencilmasken oder auch Reflektionsmasken denkbar, kann das bildseitig telezentrische System objektseitig telezentrisch oder nicht telezentrisch ausgebildet werden, wobei ein telezentrischer Strahlengang objektseitig bei Verwendung einer Reflektionsmaske nur unter Verwendung eines transmissionsmindernden Strahlenteilers möglich ist. Unebenheiten der Maske führen bei nicht telezentrischem Strahlengang im Objektraum zu Maßstabsfehlern in der Abbildung. Die Hauptstrahlwinkel am Retikel liegen daher vorzugsweise unter 10°, damit die Anforderungen an die Retikelebenheit im Bereich des technologisch realisierbaren liegen.

Das erfindungsgemäße System gemäß Figur 1 weist einen bildseitigen Telezentriefehler am Wafer von 1 mrad bei einer numerischen Apertur von 0,2 auf.

Aufgrund der hohen bildseitigen Telezentrie liegt die Eintrittspupille des letzten Spiegel S6 in oder nahe seines Brennpunktes. Bei den erfindungsgemäßen Systemen mit Zwischenbild kommt die Blende dann im vorderen, niederaperturigen Objektivteil vorwiegend zwischen dem ersten und dritten Spiegel S1, S3 zum Liegen und die dazu konjugierte Pupillenebene wird in den Fokus des letzten Spiegels abgebildet.

In der dargestellten Ausführungsform sind sämtliche Spiegel S1 - S6 asphärisch ausgeführt, wobei die maximale Asphärizität im Nutzbereich bei 7,3 μm liegt. Die niedrige Asphärizität der erfindungsgemäßen Anordnung ist insbesondere aus fertigungstechnischer Sicht vorteilhaft, da die technologischen Schwierigkeiten bei der Bearbeitung der Oberflächen der Multilayer-Spiegel mit der asphärischen Abweichung und wachsendem Gradienten der Asphäre überproportional stark ansteigen.

Der größe Einfallswinkel in der Anordnung gemäß Figur 1 tritt an S5 auf und beträgt 18,4°. An Spiegel S5 tritt auch die maximale Einfallswinkelvariation von ca. 14,7° über den Spiegel hinweg auf. Der Wellenfrontfehler der Anordnung gemäß Figur 1 bei λ = 13 nm ist besser als 0,032 λ, die Schwerpunktverschiebung der Punktbilder ist < 3 nm, die statische, maßstabskorrigierte Verzeichnung liegt bei 4 nm.

Die in der Ausführungsform gemäß Figur 1 zwischen zweitem und dritten Spiegel angeordnete Blende ist frei zugänglich. Eine freie Zugängigkeit der Blende und eine Abschattung des von S3 nach S4 laufenden Bündels durch die Blende wird bei gleichzeitig akzeptablen Einfallswinkeln auf den Spiegeln verhindert, wenn in den dargestellten Anordnungen, nachfolgende Bedingung

$$0,5 < \frac{S1S3}{S1S2} < 2$$

und

$$0,5 < \frac{S2\,Blende}{S3\,Blende} < 2$$

erfüllt sind.

Hierbei bezeichnet die Kurzschreibweise S1 S3 den mechanischen Abstand zwischen den einzelnen Komponenten, hier den Spiegeln S1 und S3.

Um die Einfallswinkel auf den Spiegeln zu vermindern ist in einer besonders bevorzugten Ausführungsform der Erfindung gemäß Fig. 1 und Fig. 3-4 der Abstand vom Retikel zu S1 kleiner als der Abstand von S2 zu S3, d.h. es gilt:

$$Retikel\ S1 < S2S3.$$

Für die mechanische Realisierung ist es besonders vorteilhaft, wenn das Retikel physikalisch hinreichend weit vor dem in Lichtrichtung ersten Spiegel - hier S2 - zu liegen kommt.

Vorliegend beträgt der Abstand Retikel S2 80 mm, ohne hierauf beschränkt zu sein.

Des weiteren ist bei der Ausführungsform der Erfindung gemäß den Figuren 1 sowie 3 bis 5 der Abstand zwischen den Spiegeln S3 und S6 so groß gewählt, daß die Spiegel hinreichend dick ausgebildet werden können, um bei den auftretenden hohen Schichtspannungen über die geforderten Festigkeitseigenschaften zu verfügen.

Besonders bevorzugt ist es, wenn nachfolgende Beziehung vorliegt:

0,3 (genutzter Durchmesser S3 + genutzter Durchmesser S6) < S3S6.

Aus der nachfolgenden Tabelle gehen in Code V-Nomenklatur die Parameter der beispielhaft in Figur 1 dargestellten Systeme hervor. Bei dem Objektiv handelt es sich um 5x-System mit einem 26 x 2 mm$^2$ Ringfeld und einer numerischen Apertur von 0,2. Der mittlere bildseitige Radius des Systems beträgt dabei ungefähr 26 mm.

Tabelle 1:

| Element Nummer | Radius | Dicke | Durchmesser | Art |
|---|---|---|---|---|
| Objekt | INF | 80.9127 | | |
| | | | 258.1723 | |
| | | 413.0257 | | |
| S1 | A(1) | -88.8251 | 197.5712 | REFL |
| | | | 195.6194 | |
| | | -324.2006 | | |
| | | | 188.6170 | |
| | | 0.0000 | | |
| S2 | A(2) | 324.2006 | 188.7078 | REFL |
| | | AperturBlende | 67.1796 | |
| | | 423.6214 | | |
| | | | 183.2180 | |
| | | 0.0000 | | |
| S3 | A(3) | -423.6214 | 184.7062 | REFL |
| | | | 519.0546 | |
| | | -74.9270 | | |
| S4 | A(4) | 498.5484 | 541.0453 | REFL |
| | | | 248.6244 | |
| | | 109.8242 | | |
| | | | 177.5488 | |
| | | 281.5288 | | |
| S5 | A(5) | -281.5288 | 65.0842 | REFL |
| S6 | A(6) | 281.5288 | 187.9549 | REFL |
| | | | 78.3999 | |
| Bild | Bildweite | 59.9202 | | |
| | | | 53.9889 | |

Asphärische Konstanten:

$$Z = \frac{(CURV)\ Y^2}{1 + (1 - (1+K)\ (CURV)^2\ Y^2)^{1/2}} + (A)\ Y^4 + (B)\ Y^6 + (C)\ Y^8 + (D)\ Y^{10}$$

(fortgesetzt)

| Asphäre | CURV | K | A | B | C | D |
|---|---|---|---|---|---|---|
| A(1) | 0.00031800 | -27.686599 | 0.00000E+00 | 1.32694E-15 | 2.00546E-20 | -8.49471E-25 |
| A(2) | 0.00094928 | -3.998204 | 0.00000E+00 | 4.03849E-15 | -6.15047E-20 | 2.73303E-25 |
| A(3) | 0.00126752 | 0.424198 | 0.00000E+00 | 1.58766E-15 | -8.27965E-20 | 2.80328E-24 |
| A(4) | 0.00123850 | 0.023155 | 0.00000E+00 | 2.46048E-17 | -1.08266E-22 | 3.75259E-28 |
| A(5) | 0.00329892 | 2.902916 | 0.00000E+00 | 1.55628E-12 | -6.71619E-17 | -5.30379E-21 |
| A(6) | 0.00277563 | 0.072942 | 0.00000E+00 | 2.96285E-16 | 3.99125E-21 | 4.55007E-26 |
| Referenz Wellenlänge = 13 nm | | | | | | |

In Figur 2 ist eine Anordnung eines Projektionsobjektives für die Mikrolithographie mit Wellenlänge $\lambda < 100$ nm gemäß der US-A-5686728 gezeigt. Gleiche Bauteile wie in Figur 1 sind mit denselben Bezugsziffern belegt.

Wie deutlich zu erkennen, ist der Abstand zwischen dem wafernächsten Spiegel S5 und dem Wafer wesentlich geringer als der Durchmesser des Spiegels und liegt vorliegend im Bereich von ungefähr 20 mm, was im EUV-Bereich aufgrund der extremen Schichtspannungen zu Festigkeitsproblemen führt.

Des weiteren weist das System gemäß dem Stand der Technik sehr hohe Asphärizitäten von +/- 50 $\mu$m und Einfallswinkel von 38° auf. Derartige Asphärizitäten und Einfallswinkel sind im EUV-Bereich unter dem Blickwinkel der Fertigungs- und Beschichtungstechnologie nicht realisierbar.

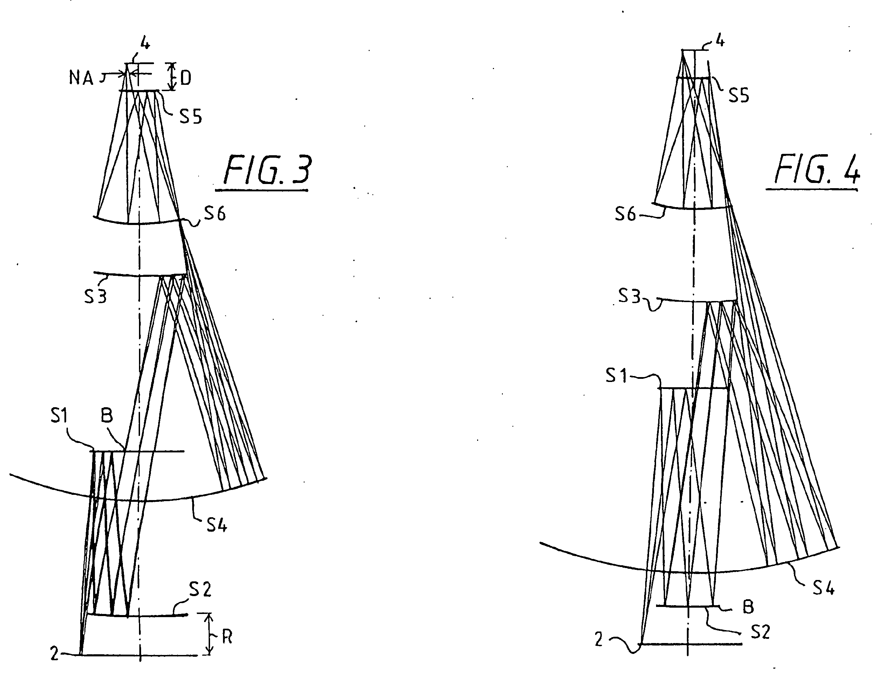

In Figur 3 ist eine alternative Ausführungsform eines erfindungsgemäßen 6-Spiegelsystems dargestellt, bei dem die Blende auf dem ersten Spiegel liegt. Gleiche Bauteile wie in Figur 1 werden wiederum mit denselben Bezugsziffern belegt.

Der optische freie Arbeitsabstand am Wafer beträgt auch bei dieser Ausführungsform wie schon bei der Ausführungsform gemäß Figur 1 60 mm und ist somit größer als der Durchmesser des wafernächsten Spiegels S5. Wie bei der Ausführungsform gemäß Figur 1 ist auch bei dem Design gemäß Figur 3 der Abstand zwischen S2 und S3 gegenüber dem Stand der Technik in Form der US-A-5686728 wesentlich erhöht worden, so daß große Inzidenzwinkel im System vermindert werden.

Im Unterschied zu der Ausgestaltung gemäß Figur 1 ist in Figur 3 die Blende B physikalisch auf den Primärspiegel gelegt. Durch diese Position wird eine sehr effiziente Abschaltung von an S2 reflektiertem Licht möglich, das bei einer physikalischen Blendenposition zwischen S1 und S2 leicht oberhalb der als schmalen Ring auszubildenden Blende passieren könnte. Bei dem in Figur 3 dargestellten Ausführungsbeispiel kann die Blende entweder als Öffnung im S1-Mutterspiegel oder hinter S1 liegend realisiert werden.

Ein weiterer Vorteil der Lösung gemäß Figur 3 ist die sphärische Ausbildung des Spiegels S4, die insbesondere unter Fertigungsaspekten einen besonderen Vorteil darstellt, da der Spiegel S4 der größte Spiegel des Systems ist. Gegenüber der Ausführungsform gemäß Figur 1 ist bei der Ausgestaltung gemäß Figur 3 die Asphärizität im Nutzbereich leicht erhöht und liegt bei 10,5 $\mu$m. Der größte Einfallswinkel tritt wie bei der Ausführungsform gemäß Figur 1 an Spiegel S5 auf und beträgt ca. 18,6°. Der Wellenfrontfehler der Anordnung gemäß Figur 3 beträgt 0,032 $\lambda$, innerhalb des 1,7 mm breiten Ringfeldes bei $\lambda = 13$ nm. Bildet man den Spiegel S4 bei der Ausgestaltung gemäß Figur 3 leicht asphärisch aus mit 0,4 $\mu$m, so kann der Wellenfrontfehler auf 0,031 $\lambda$ innerhalb eines 1,8 mm breiten Ringfeldes bei $\lambda = 13$ nm gehalten werden. Eine effiziente Ausblendung unerwünschten Lichtes erhält man nicht nur, wenn man die Blende direkt auf dem Spiegel S1 ausbildet, sondern auch dann, wenn man sie dem Spiegel S1 nachordnet. Eine besonders bevorzugte Baubedingung für eine derartige Blende ist:

$$S2S1 \leq 0,9 \times S2\text{-Blende.}$$

In Tabelle 2 sind die Konstruktionsdaten des 5x Objektives gemäß Figur 3 in Code V-Nomenklatur dargestellt, wobei der vierte Spiegel S4 sphärisch ausgebildet ist. Der mittlere Radius des 26 x 1,7 mm$^2$ - Bildfeldes beträgt wiederum 26 mm.

Tabelle 2:

| Element Nummer | Radius | Dicke | Durchmesser | Art |
|---|---|---|---|---|
| Objekt | INF | 85.2401 | | |
| | | | 256.1389 | |
| | | 358.4668 | | |
| S1 | A(1) | 0.0024 | 203.8941 | REFL |
| | | | 203.8845 | |
| | | -358.4691 | | |
| | | | 201.9677 | |
| | | 0.0000 | | |
| S2 | A(2) | 358.4691 | 201.9942 | REFL |
| | | AperturBlende | 60.7572 | |
| | | 390.5456 | | |
| | | | 187.2498 | |
| | | 0.0000 | | |
| S3 | A(3) | -390.5456 | 188.9474 | REFL |
| | | | 505.8686 | |
| | | -104.1273 | | |
| S4 | A(4) | 494.6729 | 550.3686 | REFL |
| | | | 256.9217 | |
| | | 114.3062 | | |
| | | | 181.7337 | |
| | | 281.6969 | | |
| S5 | A(5) | -281.6969 | 64.4286 | REFL |
| S6 | A(6) | 281.6969 | 187.8549 | REFL |
| | | | 78.1545 | |
| Bild | Bildweite | 60.0041 | | |
| | | | 53.6996 | |

Asphärische Konstanten:

$$Z = \frac{(CURV)\ Y^2}{1 + (1 - (1 + K)\ (CURV)^2\ Y^2)^{1/2}} + (A)\ Y^4 + (B)\ Y^6 + (C)\ Y^8 + (D)\ Y^{10}$$

(fortgesetzt)

| Asphäre | CURV | K | A | B | C | D |
|---|---|---|---|---|---|---|
| A(1) | 0.00035280 | -58.238840 | 0.00000E+00 | 2.14093E-15 | 2.29498E-20 | 0.00000E+00 |
| A(2) | 0.00097971 | -4.160335 | 0.00000E+00 | 1.54696E-15 | 8.15622E-21 | 0.00000E+00 |
| A(3) | 0.00117863 | -2.136423 | 0.00000E+00 | -1.78563E-16 | 3.45455E-20 | 0.00000E+00 |
| A(4) | 0.00124362 | 0.000000 | 0.00000E+00 | 0.00000E+00 | 0.00000E+00 | 0.00000E+00 |
| A(5) | 0.00338832 | 2.909987 | 0.00000E+00 | 7.90123E-13 | 7.04899E-17 | 0.00000E+00 |
| A(6) | 0.00278660 | 0.062534 | 0.00000E+00 | 2.79526E-16 | 7.00741 E-21 | 0.00000E+00 |
| Referenz Wellenlänge = 13 nm | | | | | | |

In Figur 4 ist eine weitere Ausführungsform der Erfindung gezeigt, wobei wiederum für gleiche Bauteile dieselben Bezugsziffern wie in den vorausgegangenen Figuren verwendet wurden.

Bei der Ausführungsform gemäß Figur 4 wurde die Blende B optisch und physikalisch auf den Sekundärspiegel bzw. zweiten Spiegel S2 gelegt.

Die Anordnung der Blende direkt auf dem Spiegel hat den Vorteil, daß diese Blende auf einem Spiegel sich mechanisch einfacher realisieren läßt.

Mit dem in Figur 4 dargestellten 4x Aufbau läßt sich innerhalb eines 2 mm breiten Ringfeldes ein Wellenfrontfehler bei $\lambda$ = 13 nm von 0,021 $\lambda$ realisieren. Die maximale Asphärizität im Nutzbereich liegt bei 11,2 $\mu$m, der größte an S5 auftretende Einfallswinkel beträgt 18,3˚. Der mittlere Bildfeldradius beträgt wiederum 26 mm.

Erfindungsgemäß ist der optische freie Arbeitsabstand zwischen Wafer und wafernächstem Spiegel S5 erfindungsgemäß größer als der Durchmesser des wafernächsten Spiegels S5 und liegt in vorliegender Ausführungsform bei ca. 59 mm.

In Tabelle 3 sind die optischen Parameter in Code V-Nomenklatur der in Figur 4 dargestellten Ausführungsform der Erfindung aufgeführt.

Tabelle 3:

| Element Nummer | Radius | Dicke | Durchmesser | Art |
|---|---|---|---|---|
| Objekt | INF | 84.0595 | | |
| | | | 205.6642 | |
| | | 473.5521 | | |
| S1 | A(1) | -145.8261 | 147.3830 | REFL |
| | | | 136.4700 | |
| | | -37.7260 | | |
| | | AperturBlende | 112.0176 | |
| | | 0.0000 | | |
| S2 | A(2) | 473.5521 | 112.1228 | REFL |
| | | | 163.5236 | |
| | | 190.4830 | | |
| | | | 184.4783 | |
| | | 0.0000 | | |
| S3 | A(3) | -190.4830 | 185.3828 | REFL |
| | | | 358.6720 | |
| | | -399.1713 | | |
| S4 | A(4) | 589.6560 | 654.5228 | REFL |
| | | | 310.1977 | |
| | | 207.5220 | | |
| | | | 175.3066 | |
| | | 276.2668 | | |
| S5 | A(5) | -276.2668 | 65.2138 | REFL |
| S6 | A(6) | 276.2668 | 182.8159 | REFL |
| | | | 77.5085 | |
| Bild | Bildweite | 59.0000 | | |
| | | | 53.9968 | |

Asphärische Konstanten:

$$Z = \frac{(CURV)\ Y^2}{1 + (1 - (1+K)\ (CURV)^2\ Y^2)^{1/2}} + (A)\ Y^4 + (B)\ Y^6 + (C)\ Y^8 + (D)\ Y^{10}$$

(fortgesetzt)

| Asphäre | CURV | K | A | B | C | D |
|---|---|---|---|---|---|---|
| A(1) | 0.00015851 | 441.008070 | 0.00000E+00 | -3.49916E-16 | 1.27478E-19 | -3.37021E-25 |
| A(2) | 0.00089932 | -5.032907 | 0.00000E+00 | -6.95852E-15 | -7.53236E-20 | -2.74751 E-24 |
| A(3) | 0.00188578 | 0.913039 | 0.00000E+00 | -1.60100E-15 | -9.53850E-20 | 1.30729E-26 |
| A(4) | 0.00108147 | 0.038602 | 0.00000E+00 | 2.48925E-18 | -5.29046E-24 | -4.37117E-31 |
| A(5) | 0.00269068 | 7.253316 | 0.00000E+00 | -5.70008E-13 | -9.32236E-17 | -6.09046E-21 |
| A(6) | 0.00281036 | 0.150957 | 0.00000E+00 | 1.30822E-15 | 1.86627E-20 | 5.08158E-25 |
| Referenz Wellenlänge = 13 nm | | | | | | |

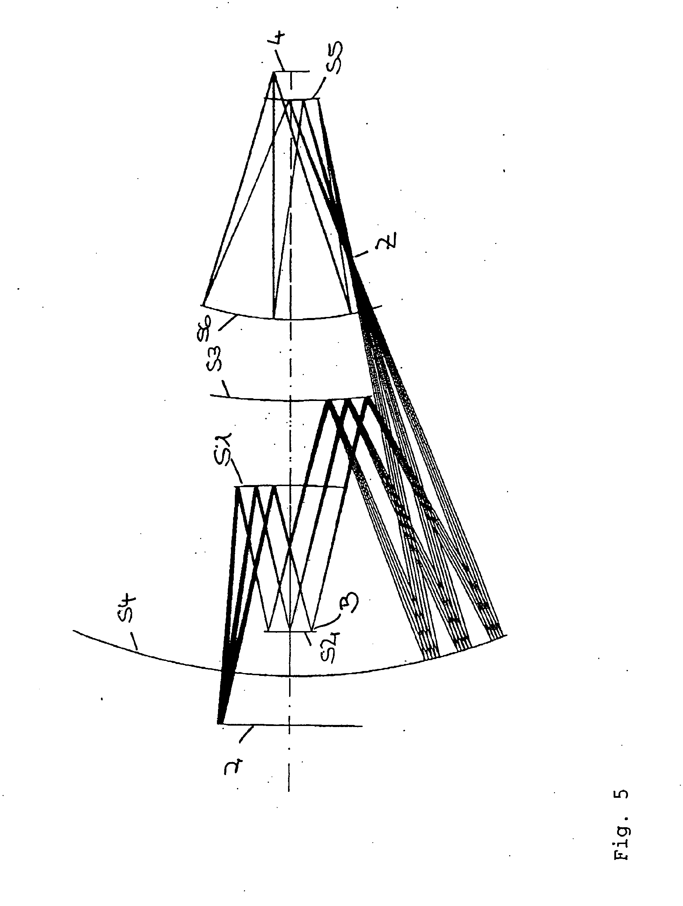

Figur 5 zeigt eine Ausführungsform der Erfindung, die einen Feldspiegel S1, ein erstes Subsystem mit zweitem bis viertem Spiegel S2 - S4 und ein zweites Subsystem mit fünftem und sechstem Spiegel S5, S6 umfaßt. Der Feldspiegel S1 mit $\beta > 0$ erzeugt ein virtuelles Bild des Objektes 2, welches durch das aus zweitem, drittem und viertem Spiegel S2, S3, S4 gebildeten erste Subsystem mit $\beta < 0$ reell in das Zwischenbild Z abgebildet wird, wobei das aus fünftem und sechstem Spiegel S5, S6 gebildete zweite Subsystem das Zwischenbild Z in das reelle Systembild der Waferebene 4 abbildet. Die numerische Apertur des Systems beträgt NA = 0,28. Der Arbeitsabstand zwischen letztem Spiegel S5 und der Waferebene entspricht mindestens der Summe aus einem Drittel des genutzten Durchmessers des wafernächsten Spiegels und einer Länge, die zwischen 20 und 30 mm liegt. Die Blende B kommt auf dem zweiten Spiegel S2 zum Liegen.

In Tabelle 4 sind die optischen Parameter der Ausführungsform gemäß Figur 5 in Code V-Nomenklatur aufgeführt.

Tabelle 4:

| Element Nummer | Radius | Dicke | Durchmesser | Art |
|---|---|---|---|---|
| Objekt | INF | 151.2625 | | |
| | | | 194.7605 | |
| | | 229.0820 | | |
| S1 | A(1) | -39.4068 | 162.9862 | REFL |
| | | | 147.1426 | |
| | | -189.6752 | | |
| | | Blende | 65.0637 | |
| | | 0.0000 | | |
| S2 | A(2) | 229.0820 | 65.1650 | REFL |
| | | | 168.3504 | |
| | | 137.5708 | | |
| | | | 230.5128 | |
| | | 0.0000 | | |
| S3 | A(3) | -137.5708 | 234.0072 | REFL |
| | | | 386.2567 | |
| | | -300.3445 | | |
| S4 | A(4) | 437.9153 | 630.7784 | REFL |
| | | | 343.1578 | |
| | | 133.0981 | | |
| | | | 257.0225 | |
| | | 353.0840 | | |
| S5 | A(5) | -353.0840 | 79.9521 | REFL |
| S6 | A(6) | 353.0840 | 264.2853 | REFL |
| | | | 78.6376 | |
| Bild | Bildweite | 44.0000 | | |
| | | | 54.0051 | |
| Asphärische Konstanten: | | | | |

| Element Nummer | Radius | Dicke | Durchmesser | Art |
|---|---|---|---|---|

$$Z = \frac{(CURV)\, Y^2}{1 + (1 - (1+K)\,(CURV)^2\, Y^2)^{1/2}} + (A)\, Y^4 + (B)\, Y^6 + (C)\, Y^8 + (D)\, Y^{10}$$

$$+ (E)\, Y^{12} + (F)\, Y^{14} + (G)\, Y^{16} + (H)\, Y^{18} + (J)\, Y^{20}$$

| Asph. | CURV | K<br>E | A<br>F | B<br>G | C<br>H | D<br>J |
|---|---|---|---|---|---|---|
| A(1) | -0.00080028 | 0.000000<br>0.00000E+00 | -3.35378E-09<br>0.00000E+00 | 5.36841E-14<br>0.00000E+00 | -7.86902E-19<br>0.000000E+00 | -5.07886E-24<br>0.000000E+00 |
| A(2) | 0.00040002 | 0.000000<br>0.00000E+00 | 1.68187E-08<br>0.00000E+00 | 2.05570E-12<br>0.00000E+00 | 2.42710E-16<br>0.00000E+00 | 5.69764E-20<br>0.00000E+00 |
| A(3) | 0.00113964 | -2.760663<br>0.00000E+00 | 0.00000E+00<br>0.00000E+00 | -3.55779E-15<br>0.00000E+00 | 1.03881E-19<br>0.00000E+00 | -3.64996E-24<br>0.00000E+00 |
| A(4) | 0.00128753 | 0.019273<br>-6.20361 E-33 | 0.00000E+00<br>0.00000E+00 | 5.82746E-18<br>0.00000E+00 | -1.77496E-22<br>0.00000E+00 | 1.64954E-27<br>0.00000E+00 |
| A(5) | 0.00373007 | 11.6888968<br>0.00000E+00 | 0.00000E+00<br>0.00000E+00 | -5.53902E-12<br>0.00000E+00 | -4.32712E-16<br>0.00000E+00 | -1.54425E-19<br>0.00000E+00 |
| A(6) | 0.00240387 | -0.002567<br>0.00000E+00 | 0.00000E+00<br>0.00000E+00 | -6.78955E-16<br>0.00000E+00 | -8.39621 E-21<br>0.00000E+00 | -2.95854E-25<br>0.00000E+00 |
| Referenz Wellenlänge = 13 nm | | | | | | |

**EP 1 772 775 B1**

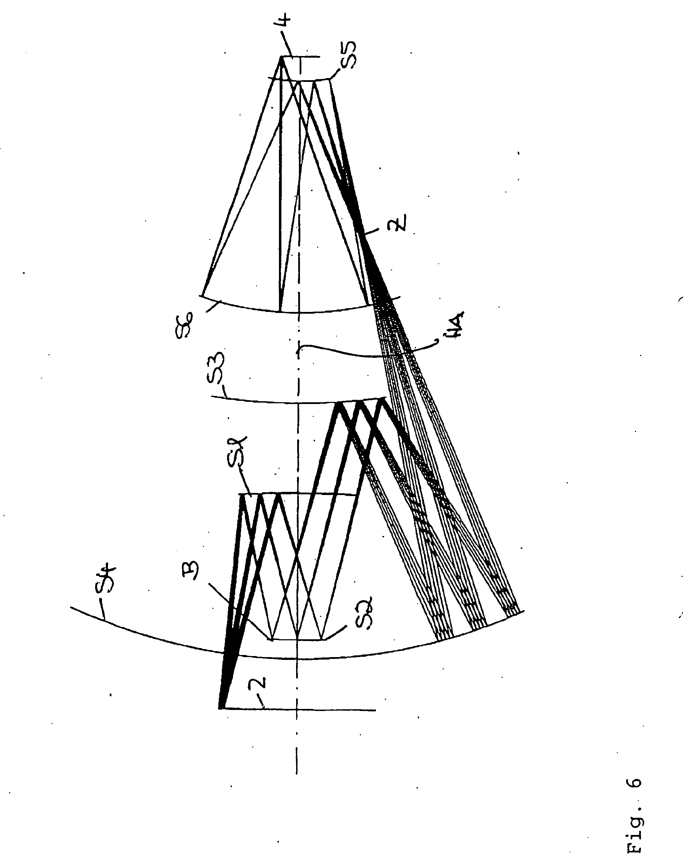

In Figur 6 ist eine zweite Ausführungsform eines 6-Spiegel-Objektives mit Feldspiegel S1, erstem und zweitem Subsystem sowie Zwischenbild Z gezeigt. Die numerische Apertur NA dieses Systems liegt bei NA = 0,30; die Blende B wird wie bei der Ausführungsform gemäß Figur 5 auf dem zweiten Spiegel S2 ausgebildet.

Die optischen Parameter der Ausführungsform gemäß Figur 6 sind in Tabelle 5 in Code V-Nomenklatur aufgeführt.

**20**

Tabelle 5:

| Element Nummer | Radius | Dicke | Durchmesser | Art |
|---|---|---|---|---|
| Objekt | INF | 103.2808 | | |
| | | | 197.1874 | |
| | | 219.3042 | | |
| S1 | A(1) | -39.2890 | 157.6222 | REFL |
| | | | 142.1492 | |
| | | -180.0152 | | |
| | | Blende | 67.2659 | |
| | | 0.0000 | | |
| S2 | A(2) | 219.3042 | 67.4347 | REFL |
| | | | 167.6895 | |
| | | 131.2051 | | |
| | | | 228.0182 | |
| | | 0.0000 | | |
| S3 | A(3) | -131.2051 | 232.3162 | REFL |
| | | | 401.4441 | |
| | | -247.5850 | | |
| S4 | A(4) | 378.7901 | 613.5493 | REFL |
| | | | 355.7774 | |
| | | 134.4001 | | |
| | | | 268.3735 | |
| | | 348.5086 | | |
| S5 | A(5) | -348.5086 | 81.5255 | REFL |
| S6 | A(6) | 348.5086 | 269.2435 | REFL |
| | | | 75.4983 | |
| Bild | Bildweite | 36.1195 | | |
| | | | 53.9942 | |

Asphärische Konstanten:

(fortgesetzt)

| Element Nummer | Radius | Dicke | Durchmesser | Art |
|---|---|---|---|---|

$$Z = \frac{(CURV)\, Y^2}{1 + (1 - (1+K)\,(CURV)^2\, Y^2)^{1/2}} + (A)\, Y^4 + (B)\, Y^6 + (C)\, Y^8 + (D)\, Y^{10}$$

$$+ (E)\, Y^{12} + (F)\, Y^{14} + (G)\, Y^{16} + (H)\, Y^{18} + (J)\, Y^{20}$$

| Asph. | CURV | K | A | B | C | D |
| | | E | F | G | H | J |
|---|---|---|---|---|---|---|
| A(1) | -0.00061615 | 0.000000 | -5.19402E-09 | 1.09614E-13 | -3.44621 E-18 | 1.58573E-22 |
| | | -7.07209E-27 | 0.00000E+00 | 0.00000E+00 | 0.00000E+00 | 0.00000E+00 |
| A(2) | 0.00066911 | 0.000000 | 1.69112E-08 | 2.39908E-12 | 2.89763E-16 | 1.00572E-19 |
| | | 1.84514E-29 | 0.00000E+00 | 0.00000E+00 | 0.00000E+00 | 0.00000E+00 |
| A(3) | 0.00140031 | 0.000000 | -8.71271E-10 | -1.47622E-15 | -3.40869E-20 | 4.32196E-24 |
| | | -2.23484E-28 | 0.00000E+00 | 0.00000E+00 | 0.00000E+00 | 0.00000E+00 |
| A(4) | 0.00143731 | 0.000000 | 2.18165E-12 | 2.65405E-17 | -2.01757E-22 | 1.14856E-28 |
| | | 1.49857E-32 | -8.61043E-38 | 0.00000E+00 | 0.00000E+00 | 0.00000E+00 |
| A(5) | 0.00378996 | 0.000000 | 8.54406E-08 | 2.25929E-12 | 3.36372E-16 | 1.92565E-20 |
| | | 5.75469E-24 | 0.00000E+00 | 0.00000E+00 | 0.00000E+00 | 0.00000E+00 |
| A(6) | 0.00246680 | 0.000000 | -3.61754E-12 | -8.29704E-16 | -1.53440E-20 | -2.24433E-25 |
| | | 5.91279E-30 | 0.00000E+00 | 0.00000E+00 | 0.00000DE+00 | 0.00000E+00 |

Referenz Wellenlänge = 13 nm

EP 1 772 775 B1

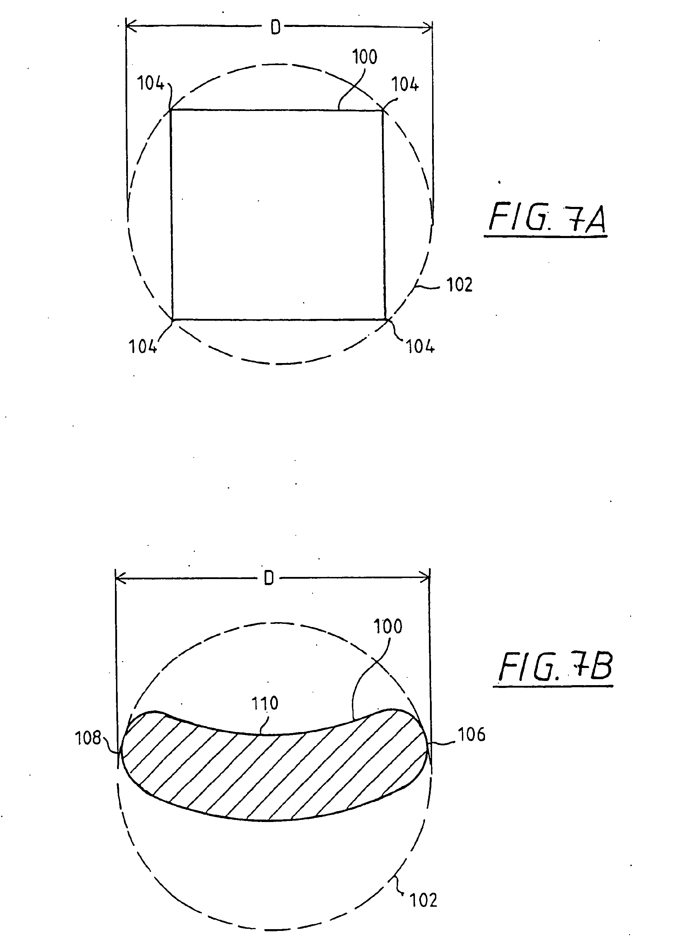

Die Figuren 7A und 7B verdeutlichen nochmals was in der vorliegenden Anmeldung unter dem genutzten Durchmesser D zu verstehen ist.

Beispielhaft sei das ausgeleuchtete Feld 100 auf einem Spiegel in Figur 7A ein Rechteckfeld. Der genutzte Durchmesser D ist dann der Durchmesser des Hüllkreises 102, der das Rechteck 100 umschließt, wobei die Ecken 104 des Rechteckes 100 auf den Hüllkreis 102 zu liegen kommen.

In Figur 7B ist ein zweites Beispiel dargestellt. Das ausgeleuchtete Feld 100 weist eine Nierenform auf, wie für den Nutzbereich bei Verwendung der erfindungsgemäßen Objektive in einer Mikrolithographie-Projektionsbelichtungsanlage erwartet. Der Hüllkreis 102 umschließt die Nierenform völlig und fällt an zwei Punkten 106, 108 mit dem Rand 110 der Nierenform zusammen. Der genutzte Durchmesser D ergibt sich dann aus dem Durchmesser des Hüllkreises 102.

Mit der Erfindung wird somit erstmals ein 6-Spiegel-Projektionsobjektiv mit einem Abbildungsmaßstab von vorzugsweise 4x, 5x sowie 6x für den bevorzugten Einsatz in einem EUV-Ringfeldprojektionssystem angegeben, das sowohl die notwendige Auflösung bei gefordertem Bildfeld wie auch Konstruktionsbedingungen aufweist, welche eine funktionsgerechte Bauausführung ermöglichen, da die Asphären hinreichend mild, die Winkel hinreichend klein für die Schichten und die Bauräume für die Spiegelträger hinreichend groß sind.

**Patentansprüche**

1. Mikrolithographie-Projektionsobjektiv für Wellenlängen < 100 nm mit einem ersten Spiegel (S1), einem zweiten Spiegel (S2), einem dritten Spiegel (53), einem vierten Spiegel (54), einem fünften (S5) und einem sechsten Spiegel (S6) mit Ringfeld; wobei
die bildseitige numerische Apertur (NA) $\geq$ 0,15 ist,
die bildseitige Breite eines Ringfeldes W $\geq$ 1,0 mm ist, **dadurch gekennzeichnet, dass** Einfallswinkel (AOI) relativ zur Flächennormalen aller Strahlen auf allen Spiegeln durch

$$AOI \leq 23° - 35° \, (0,25 - NA) - 0,2° /_{mm} \, (2 \, mm - W)$$

beschränkt sind, wobei
NA: bildseitige numerische Apertur
W: bildseitige Breite eines Ringfeldes

2. Mikrolithographie-Projektionsobjektiv gemäß Anspruch 1,
**dadurch gekennzeichnet, dass**
der dem zu belichtenden Objekt vorzugsweise dem Wafer am nächsten kommenden Spiegel derart angeordnet ist, dass ,

   - der bildseitige optische freie Arbeitsabstand mindestens dem genutzten Durchmesser D dieses wafernächsten Spiegels entspricht und/oder
   - der bildseitige optische freie Arbeitsabstand mindestens der Summe aus einem Drittel des genutzten Durchmessers D dieses Spiegels und einer Länge, die zwischen 20 mm und 30 mm liegt, beträgt und/oder
   - der bildseitige optische freie Arbeitsabstand mindestens 50 mm, vorzugsweise 60 mm, beträgt.

3. Mikrolithographie-Projektionsobjektiv gemäß einem der Ansprüche 1 bis 2,
**dadurch gekennzeichnet, dass**
eine Spitze-Spitze-Abweichung (A) von Asphären gegenüber der im Nutzbereich bestpassenden Sphäre auf allen Spiegeln durch

$$A \leq 19 \, \mu m - 102 \, \mu m (0,25 - NA) - 0,7 \, \frac{\mu m}{mm} \, (2 \, mm - W)$$

beschränkt ist, wobei:

NA: bildseitige numerische Apertur

W: bildseitige Breite eines Ringfeldes

4. Mikrolithographie-Projektionsobjektiv nach einem der Ansprüche 1 bis 3,
**dadurch gekennzeichnet, dass**
die Spiegel derart angeordnet sind, dass die Lichtführung obskurationsfrei ist.

5. Mikrolithographie-Projektionsobjektiv nach einem der Ansprüche 1 bis 4,
**dadurch gekennzeichnet, dass**
die Spiegelflächen auf zu einer Hauptachse (HA) rotationssymmetrischen Flächen angeordnet sind.

6. Mikrolithographie-Projektionsobjektiv nach einem der Ansprüche 1 bis 5,
**dadurch gekennzeichnet, dass**
im Projektionsobjektiv nach dem vierten Spiegel (S4) ein Zwischenbild ausgebildet wird.

7. Mikrolithographie-Projektionsobjektiv nach Anspruch 6,
**dadurch gekennzeichnet, dass**
eine Blende (B) im Lichtweg bzw. Strahlengang zwischen zweitem (S2) und drittem Spiegel (S3) angeordnet ist.

8. Mikrolithographie-Projektionsobjektiv nach Anspruch 7,
**dadurch gekennzeichnet, dass**
die Abstände zwischen erstem, zweitem und drittem Spiegel derart gewählt werden, dass die Blende frei zugänglich ist.

9. Mikrolithographie-Projektionsobjektiv nach Anspruch 8,
**dadurch gekennzeichnet, dass**
der Abstand von erstem und drittem Spiegel (S1/S3) zum Abstand von erstem und zweitem Spiegel (S1/S2) im Bereich

$$0,5 < \frac{S1S3}{S1S2} < 2$$

liegt.

10. Mikrolithographie-Projektionsobjektiv nach einem der Ansprüche 1 bis 9,
**dadurch gekennzeichnet, dass**
die Blende (B) im Strahlengang zwischen zweitem (S2) und drittem Spiegel (S3) am Körper des ersten Spiegels (S1) angeordnet ist.

11. Mikrolithographie-Projektionsobjektiv nach einem der Ansprüche 3 bis 10,
**dadurch gekennzeichnet, dass**
die Spitze-Spitze-Abweichung (A) der Asphären gegenüber der im Nutzbereich bestpassenden Sphären auf allen Spiegeln durch

$$A \leq 12\ \mu m - 64\ \mu m (0,25 - NA) - 0,3\ \frac{\mu m}{mm}\ (2\ mm - W)$$

beschränkt ist, wobei

NA: bildseitige numerische Apertur

W: bildseitige Breite eines Ringfeldes.

12. Mikrolithographie-Projektionsobjektiv nach einem der Ansprüche 1 bis 5,
**dadurch gekennzeichnet, dass**
eine Blende (B) auf oder nahe beim zweiten Spiegel (S2) angeordnet ist.

**13.** Mikrolithographie-Projektionsobjektiv nach Anspruch 12,
**dadurch gekennzeichnet, dass**
der Abstand vom ersten und dritten Spiegel (S1/S3) zum Abstand von erstem und zweitem Spiegel (S1/S2) im Bereich

$$0,3 < \frac{S1S3}{S1S2} < 2$$

und der Abstand von zweitem und drittem Spiegel (S2/S3) zum Abstand von drittem und viertem Spiegel (S3/S4) im Bereich

$$0,7 < \frac{S2S3}{S3S4} < 1,4$$

liegt.

**14.** Mikrolithographie-Projektionsobjektiv nach einem der Ansprüche 1 bis 13,
**dadurch gekennzeichnet, dass**
sämtliche Spiegel asphärisch ausgebildet sind.

**15.** Mikrolithographie-Projektionsobjektiv nach einem der Ansprüche 1 bis 14,
**dadurch gekennzeichnet, dass**
höchstens fünf Spiegel asphärisch sind.

**16.** Mikrolithographie-Projektionsobjektiv nach einem der Ansprüche 1 bis 15,
**dadurch gekennzeichnet, dass** ,
der zweite bis sechste Spiegel (S2 - S6) in der Reihenfolge konkav-konvexkonkav-konvex-konkav ausgebildet ist.

**17.** Mikrolithographie-Projektionsobjektiv nach einem der Ansprüche 1 bis 16,
**dadurch gekennzeichnet, dass**
der rms-Wellenfrontfehler des Systems höchstens 0,07 $\lambda$, bevorzugt 0,03 $\lambda$, über das gesamte Bildfeld beträgt.

**18.** Mikrolithographie-Projektionsobjektiv gemäß Anspruch 17,
**dadurch gekennzeichnet, dass**
das Bildfeld mindestens 1,0 mm breit ist.

**19.** Mikrolithographie-Projektionsobjektiv nach einem der Ansprüche 1 bis 18,
**dadurch gekennzeichnet, dass**
es bildseitig telezentrisch ist.

**20.** Mikrolithographie-Projektionsobjektiv nach Anspruch 19,
**dadurch gekennzeichnet, dass**
es objektseitig telezentrisch ist.

**21.** Mikrolithographie-Projektionsobjektiv nach einem der Ansprüche 1 bis 19,
**dadurch gekennzeichnet, dass**
der Hauptstrahl am Objekt zur optischen Achse hinläuft.

**22.** Mikrolithographie-Projektionsobjektiv nach einem der Ansprüche 6 bis 21,
**dadurch gekennzeichnet, dass**
der Spiegel mit der betragsmäßig kleinsten Brennweite nach dem Zwischenbild liegt.

**23.** Mikrolithographie-Projektionsobjektiv nach einem der Ansprüche 1 bis 22,
**dadurch gekennzeichnet, dass**
der Abstand von drittem und sechstem Spiegel (S3/S6) nachfolgender Beziehung genügt:

**0,3 (genutzter Durchmesser S3 + genutzter Durchmesser S6) < S3S6.**

**24.** Projektionsbelichtungsanlage mit einem Mikrolithographie-Projektionsobjektiv nach einem der Ansprüche 1 bis 23, **dadurch gekennzeichnet, dass** eine Reflektionsmaske vorgesehen ist.

**25.** Projektionsbelichtungsanlage mit einem Mikrolithographie-Projektionsobjektiv gemäß einem der Ansprüche 1 bis 23, **dadurch gekennzeichnet, dass** eine Transmissionsmaske vorgesehen ist.

**26.** Projektionsbelichtungsanlage nach Anspruch 24, **dadurch gekennzeichnet, dass** die Projektionsbelichtungsanlage eine Beleuchtungseinrichtung zur Beleuchtung eines Ringfeldes umfasst.

**27.** Verfahren zur Chipherstellung mit einer Projektionsbelichtungsanlage gemäß einem der Ansprüche 24 bis 26.

**Claims**

**1.** A microlithography projection objective for wavelengths < 100 nm with a first mirror (S1), a second mirror (S2), a third mirror (S3), a fourth mirror (S4), a fifth mirror (S5) and a sixth mirror (S6) with ring field, with the image-side aperture (NA) being $\geq$ 0.15, image-side width of a ring field being $\geq$ 1.0 mm, **characterized in that** the angles of incidence (AOI) relative to the surface normal of all rays on all mirrors are limited by

$$AOI \leq 23° - 35° \left(0,25 - NA\right) - 0,2°/_{mm} \left(2\ mm - W\right)$$

with NA being the image-side numerical aperture and W being the image-side width of a ring field.

**2.** A microlithography projection objective according to claim 1, **characterized in that** the mirror next to the object to be exposed, preferably the wafer, is disposed in such a way that

- the image-side optical free working distance corresponds to at last the used diameter D of this mirror next to the wafer and/or
- the image-side optical free working distance is at least the sum of one-third of the used diameter D of this mirror and a length of between 20 mm and 30 mm, and/or
- the image-side optical free working distance is at least 50 mm, preferably 60 mm.

**3.** A microlithography projection objective according to one of the claims 1 to 2, **characterized in that** a peak-peak deviation (A) of the aspheres is limited with respect to the sphere best fitting in the useful area on all mirrors by

$$A \leq 19\ \mu m - 102\ \mu m \left(0,25 - NA\right) - 0,7\ \frac{\mu m}{mm} \left(2\ mm - W\right)$$

with NA being the image-side numerical aperture and W being the image-side width of a ring field.

**4.** A microlithography projection objective according to one of the claims 1 to 3, **characterized in that** the mirrors are disposed in such a way that the light guidance is obstruction-free.

5. A microlithography projection objective according to one of the claims 1 to 4, **characterized in that** the mirror surfaces are arranged on surfaces which are rotationally symmetrical to the principal axis (HA).

6. A microlithography projection objective according to one of the claims 1 to 5, **characterized in that** an intermediate image is formed in the projection objective after the fourth mirror (S4).

7. A microlithography projection objective according to claim 6, **characterized in that** an aperture stop (B) is disposed in the light path or ray path between the second (S2) and third mirror (S3).

8. A microlithography projection objective according to claim 7, **characterized in that** the distances between the first, second and third mirror are chosen in such a way that the aperture stop is freely accessible.

9. A microlithography projection objective according to claim 8, **characterized in that** the distance of first and third mirror (S1/S3) in relation to the distance of first and second mirror (S1/S2) lies within the range of

$$0,5 < \frac{S1S3}{S1S2} < 2 \; .$$

10. A microlithography projection objective according to one of the claims 1 to 9, **characterized in that** the aperture stop (B) in the ray path between the second (S2) and third mirror (S3) is disposed on the body of the first mirror (S1).

11. A microlithography projection objective according to one of the claims 3 to 10, **characterized in that** the peak-to-peak deviation (A) of the aspheres is limited with respect to the spheres best fitting in the useful area on all mirrors by

$$A \leq 12 \; \mu m - 64 \; \mu m (0,25 - NA) - 0,3 \; \frac{\mu m}{mm} (2 \; mm - W)$$

with NA being the image-side numerical aperture and W being the image-side width of a ring field.

12. A microlithography projection objective according to one of the claims 1 to 5, **characterized in that** an aperture stop (B) is disposed on or near to the second mirror (S2).

13. A microlithography projection objective according to claim 12, **characterized in that** the distance of first and third mirror (S1/S3) in relation to the distance of first and second mirror (S1/S2) lies within the range of

$$0,3 < \frac{S1S3}{S1S2} < 2$$

and the distance of second and third mirror (S2/S3) in relation to the distance of third and fourth mirror (S3/S4) lies within the range of

$$0,7 < \frac{S2S3}{S3S4} < 1,4 \; .$$

14. A microlithography projection objective according to one of the claims 1 to 13, **characterized in that** all mirrors are arranged in an aspheric way.

**15.** A microlithography projection objective according to one of the claims 1 to 14, **characterized in that** a maximum of five mirrors are aspheric.

**16.** A microlithography projection objective according to one of the claims 1 to 15, **characterized in that** the second to sixth mirror (S2 to S5) are arranged in a concave-convex-concave-convex-concave sequence.

**17.** A microlithography projection objective according to one of the claims 1 to 16, **characterized in that** the rms wave front error of the system is a maximum of 0.07 $\lambda$, preferably 0.03 $\lambda$, over the whole image field.

**18.** A microlithography projection objective according to claim 17, **characterized in that** the image field is at least 1.0 mm wide.

**19.** A microlithography projection objective according to one of the claims 1 to 18, **characterized in that** it is telecentric on the image side.

**20.** A microlithography projection objective according to claim 19, **characterized in that** it is telecentric on the object side.

**21.** A microlithography projection objective according to one of the claims 1 to 19, **characterized in that** the principal ray on the object runs to the optical axis.

**22.** A microlithography projection objective according to one of the claims 6 to 21, **characterized in that** the mirror with the numerically smallest focal length lies behind the intermediate image.

**23.** A microlithography projection objective according to one of the claims 1 to 22, **characterized in that** the distance of third and sixth mirror (S3/S6) satisfies the following relationship:

$$0.3 \text{ (used diameter S3 + used diameter S6)} < \text{S3S6}.$$

**24.** A projection exposure apparatus with a microlithography projection objective according to one of the claims 1 to 23, **characterized in that** a reflection mask is provided.

**25.** A projection exposure apparatus with a microlithography projection objective according to one of the claims 1 to 23, **characterized in that** a transmission mask is provided.

**26.** A projection exposure apparatus according to claim 24, **characterized in that** the projection exposure apparatus comprises an illuminating device for illuminating a ring field.

**27.** A chip manufacturing method with a projection exposure apparatus according to one of the claims 24 to 26.

**Revendications**

**1.** Objectif de projection pour microlithographie pour les longueurs d'ondes < 100 nm avec un premier miroir (S1), un deuxième miroir (S2), un troisième miroir (S3), un quatrième miroir (S4), un cinquième (S5) et un sixième miroir (S6) avec un champ annulaire, dans lequel
l'ouverture numérique (NA) du côté image est $\geq$ 0,15,
la largeur du côté image d'un champ annulaire W est $\geq$ 1,0 mm,
**caractérisé en ce que** l'angle d'incidence (AOI) par rapport à la normale de surface de tous les rayons sur tous les miroirs est limité par

$$AOI \leq 23° - 35° \ (0,25 - NA) - 0,2°/mm \ (2 \text{ mm} - W)$$

où :

NA : ouverture numérique du côté image,

W : largeur du côté image d'un champ annulaire.

2. Objectif de projection pour microlithographie selon la revendication 1, **caractérisé en ce que** le miroir venant le plus près de l'objet à exposer, de préférence de la plaquette, est disposé de telle manière que

- la distance de travail optique libre du côté image est au moins égale au diamètre utilisé D de ce miroir le plus proche de la plaquette
et/ou
- la distance de travail optique libre du côté image est égale au moins à la somme d'un tiers du diamètre utilisé D de ce miroir et d'une longueur comprise entre 20 mm et 30 mm,
et/ou
- la distance de travail optique libre du côté image est d'au moins 50 mm, de préférence de 60 mm.

3. Objectif de projection pour microlithographie selon l'une des revendications 1 à 2, **caractérisé en ce qu'**un écart de pointe à pointe (A) d'asphères par rapport à la sphère qui s'adapte le mieux dans la zone utile est limité sur tous les miroirs par

$$A \leq 19 \ \mu m - 102 \ \mu m \ (0,25\text{-}NA) - 0,7 \ \frac{\mu m}{mm} \ (2 \ mm - W)$$

où :

NA : ouverture numérique du côté image,

W : largeur du côté image d'un champ annulaire.

4. Objectif de projection pour microlithographie selon l'une des revendications 1 à 3, **caractérisé en ce que** les miroirs sont disposés de telle façon que le guidage de la lumière se fait sans occultation.

5. Objectif de projection pour microlithographie selon l'une des revendications 1 à 4, **caractérisé en ce que** les surfaces des miroirs sont disposées sur des surfaces symétriques dans le sens de la rotation par rapport à un axe principal (HA).

6. Objectif de projection pour microlithographie selon l'une des revendications 1 à 5, **caractérisé en ce qu'**une image intermédiaire est formée dans l'objectif de projection après le quatrième miroir (S4).

7. Objectif de projection pour microlithographie selon la revendication 6, **caractérisé en ce qu'**un diaphragme (B) est disposé dans le trajet de la lumière ou le trajet des rayons entre le deuxième miroir (S2) et le troisième (S3).

8. Objectif de projection pour microlithographie selon la revendication 7, **caractérisé en ce que** les distances entre les premier, deuxième et troisième miroirs sont choisies de telle manière que le diaphragme soit librement accessible.

9. Objectif de projection pour microlithographie selon la revendication 8, **caractérisé en ce que** le rapport entre la distance du premier miroir au troisième (S1/S3) et la distance du premier miroir au deuxième (S1/S2) est compris dans la plage

$$0,5 < \frac{S1S3}{S1S2} < 2.$$

10. Objectif de projection pour microlithographie selon l'une des revendications 1 à 9, **caractérisé en ce que** le diaphragme (B) est disposé dans le trajet des rayons entre le deuxième miroir (S2) et le troisième (S3) sur le corps du premier miroir (S1).

11. Objectif de projection pour microlithographie selon l'une des revendications 3 à 10, **caractérisé en ce que** l'écart de pointe à pointe (A) des asphères par rapport aux sphères s'ajustant le mieux dans la zone utile est limité sur tous les miroirs par

$$A \leq 12~\mu m - 64~\mu m~(0{,}25\text{-}NA) - 0{,}3~\frac{\mu m}{mm}~(2~mm - W)$$

où :

NA : ouverture numérique du côté image
W : largeur du côté image d'un champ annulaire.

12. Objectif de projection pour microlithographie selon l'une des revendications 1 à 5, **caractérisé en ce qu'**un diaphragme (B) est disposé sur le deuxième miroir (S2) ou à proximité.

13. Objectif de projection pour microlithographie selon la revendication 12, **caractérisé en ce que** le rapport entre la distance du premier miroir au troisième (S1/S3) et la distance du premier miroir au deuxième (S1/S2) est compris dans la plage

$$0{,}3 < \frac{S1S3}{S1S2} < 2$$

et le rapport entre distance du deuxième miroir au troisième (S2/S3) et la distance du troisième miroir au quatrième (S3/S4) est compris dans la plage

$$0{,}7 < \frac{S2S3}{S3S4} < 1{,}4.$$

14. Objectif de projection pour microlithographie selon l'une des revendications 1 à 13, **caractérisé en ce que** tous les miroirs ont une forme asphérique.

15. Objectif de projection pour microlithographie selon l'une des revendications 1 à 14, **caractérisé en ce que** cinq miroirs au maximum sont asphériques.

16. Objectif de projection pour microlithographie selon l'une des revendications 1 à 15, **caractérisé en ce que** les deuxième à sixième miroirs (S2-S6) sont conformés selon la séquence concave-convexe-concave-convexe-concave.

17. Objectif de projection pour microlithographie selon l'une des revendications 1 à 16, **caractérisé en ce que** l'erreur de front d'onde quadratique moyenne du système est au maximum de 0,07 λ, de préférence de 0,03 λ, sur tout le champ d'image.

18. Objectif de projection pour microlithographie selon la revendication 17, **caractérisé en ce que** le champ d'image est large d'au moins 1,0 mm.

19. Objectif de projection pour microlithographie selon l'une des revendications 1 à 18, **caractérisé en ce qu'**il est télécentrique du côté image.

20. Objectif de projection pour microlithographie selon la revendication 19, **caractérisé en ce qu'**il est télécentrique du côté objet.

21. Objectif de projection pour microlithographie selon l'une des revendications 1 à 19, **caractérisé en ce que** le faisceau principal sur l'objet va jusqu'à l'axe optique.

**22.** Objectif de projection pour microlithographie selon l'une des revendications 6 à 21, **caractérisé en ce que** le miroir ayant la plus petite distance focale quantitative se trouve après l'image intermédiaire.

**23.** Objectif de projection pour microlithographie selon l'une des revendications 1 à 22, **caractérisé en ce que** la distance entre le troisième miroir et le sixième (S3/S6) satisfait la relation suivante :

$$0,3 \ (\text{diamètre utilisé de S3} + \text{diamètre utilisé de S6}) < \text{S3S6}.$$

**24.** Installation d'exposition par projection avec un objectif de projection pour microlithographie selon l'une des revendications 1 à 23, **caractérisée en ce qu'**un masque de réflexion est prévu.

**25.** Installation d'exposition par projection avec un objectif de projection pour microlithographie selon l'une des revendications 1 à 23, **caractérisée en ce qu'**un masque de transmission est prévu.

**26.** Installation d'exposition par projection selon la revendication 24, **caractérisée en ce que** l'installation d'exposition par projection comprend une installation d'exposition pour l'exposition d'un champ annulaire.

**27.** Procédé pour la fabrication de puces avec une installation d'exposition par projection selon l'une des revendications 24 à 26.

_FIG.1_

_FIG.2_

EP 1 772 775 B1

FIG. 4

FIG. 3

Fig. 5

EP 1 772 775 B1

Fig. 6

35

_FIG. 7A_

_FIG. 7B_

**IN DER BESCHREIBUNG AUFGEFÜHRTE DOKUMENTE**

**In der Beschreibung aufgeführte Patentdokumente**

- US 5686728 A
- EP 0779528 A
- US 5815310 A
- JP 95283116 A